# EUROPÄISCHE PATENTSCHRIFT

(11) **EP 2 265 104 B1**
(45) Veröffentlichungstag und Bekanntmachung des Hinweises auf die Patenterteilung: **29.05.2013**
(21) Anmeldenummer: 10182416.7
(22) Anmeldetag: 29.07.2005
(51) Int. Cl.: H05K 13/00

(54) **Stützeinheit**
Support unit
Unité de support

(30) Priorität: 02.08.2004 DE 102004037501
(43) Veröffentlichungstag der Anmeldung: 22.12.2010
(62) Teilanmeldung aus: 05016520.8
(73) Patentinhaber: Fromm, Bernd, 72768 Reutlingen (DE)
(72) Erfinder: Fromm, Bernd, 72768 Reutlingen (DE)
(74) Vertreter: Hoeger, Stellrecht & Partner Patentanwälte

(56) Entgegenhaltungen:
- WO-A-00/16600
- US-A- 5 984 293
- US-B1- 6 711 797
- US-B1- 6 726 195

## Beschreibung

Die Erfindung betrifft eine Stützeinheit für die Abstützung einer Baugruppe auf einer höhenvariierenden Oberflächenkontur, insbesondere für die Abstützung von mit Bauteilen bestückten Leiterplatten, umfassend ein Basisgehäuse, in welchem mehrere Stützelemente in Richtung ihrer Längsrichtung zwischen einer eingefahrenen Stellung und einer ausgefahrenen Stellung bewegbar sind, Verschiebeeinheiten, mit denen die Stützelemente in Richtung der ausgefahrenen Stellung beaufschlagbar sind, und Fixiereinheiten, mit welchen die Stützelementen in ihren jeweiligen Stellungen gegenüber dem Basisgehäuse fixierbar sind, wobei die Fixiereinheiten auf die Stützelemente wirkende Klemmkörper umfassen, die durch eine Betätigungseinrichtung beaufschlagbar sind.

Bei derartigen, aus der WO 00/16600, bekannten Stützelementen besteht das Problem, eine vorteilhafte Kraftbeaufschlagung der Stützelemente zum Anlegen derselben an der höhenvariierenden Oberflächenkontur der Baugruppe zu realisieren.

Der Erfindung liegt daher die Aufgabe zugrunde, eine Stützeinheit der gattungsgemäßen Art derart zu verbessern, dass eine vorteilhafte Beaufschlagung der Stützelemente möglich ist.

Diese Aufgabe wird bei einer Stützeinheit der eingangs beschriebenen Art erfindungsgemäß durch die Merkmale des Anspruchs 1 gelöst.

Der Vorteil der erfindungsgemäßen Lösung ist somit darin zu sehen, dass mit dieser die Möglichkeit besteht, durch Variation des Drucks die Kraft, mit welcher die Stützelemente auf die Baugruppe wirken, einzustellen, so dass je nach Gewicht der Baugruppe eine Anpassung der von den Stützelemente ausgeübten Kräfte möglich ist.

Darüber hinaus hat die erfindungsgemäße Lösung noch den Vorteil, dass die Reibung des jeweiligen Schafts beim Verschieben desselben reduziert werden kann, so dass der Schaft einerseits in der Verschieberichtung leicht bewegbar ist und bereits durch geringe von der Druckluft ausgeübte Kräfte in seine maximal ausgefahrene Stellung bewegt werden kann.

Damit lassen sich bei der erfindungsgemäßen Lösung, insbesondere auch geringe, auf die Stützelemente wirkende Kräfte einstellen, um mit wenig Kraft empfindliche Bauteile der Baugruppe beaufschlagen zu können.

Weitere Merkmale sind Gegenstand der Unteransprüche.

Hinsichtlich der Betätigungseinrichtung für die Klemmkörper wurden bislang keine näheren Angaben gemacht. Beispielsweise wäre es denkbar, die Betätigungseinrichtung durch Keil- oder Exzentergetriebe oder -vorrichtungen auszubilden, durch welche ein Druck auf die Klemmkörper erzeugbar wäre.

Eine funktionssichere und konstruktiv einfach realisierbare Lösung sieht jedoch vor, dass die Betätigungseinrichtung mittels eines unter Druck setzbaren Mediums eine Kraftwirkung auf die Klemmkörper ausübt.

Dabei könnte die Betätigungseinrichtung beispielsweise einzelne durch das Medium beaufschlagbare Kolben aufweisen um auf die Klemmkörper einzuwirken.

Besonders zweckmäßig ist es jedoch, wenn die Betätigung mindestens ein durch das Medium expandierbares Element aufweist, welches auf mindestens einen der Klemmkörper einwirkt.

Besonders zweckmäßig ist dabei eine Lösung, bei welcher die Betätigungseinrichtung als expandierbares Element einen expandierbaren Schlauchkörper aufweist.

Der Schlauchkörper kann dabei beliebig verlaufen.

Eine konstruktiv besonders zweckmäßige Lösung sieht dabei vor, dass der Schlauchkörper quer zu den Längsachsen der Stützelemente verläuft und dabei insbesondere seitlich an den Klemmkörpern vorbeiläuft.

Besonders zweckmäßig ist beim Vorsehen eines Schlauchkörpers, wenn mit diesem mehrere Klemmkörper beaufschlagbar sind.

Der Schlauchkörper könnte dabei mäanderförmig an den Klemmkörpern vorbeigeführt sein.

Zweckmäßigerweise ist vorgesehen, dass der Schlauchkörper längs einer Reihe von Stützelementen verläuft und deren Klemmkörper durch den Schlauchkörper beaufschlagbar sind.

Um bei einem expandierbaren Element sicherzustellen, dass eine möglichst große Kraft auf den Klemmkörper ausgeübt wird, ist zweckmäßigerweise vorgesehen, dass das expandierbare Element auf seiner auf den Klemmkörper wirkenden Seite mit einer Wandversteifung versehen ist.

Eine derartige Wandversteifung schafft die Möglichkeit, großflächig von dem expandieren Element die Expansionsbewegung aufzunehmen und auf den Klemmkörper überzuleiten.

Daher ist vorzugsweise vorgesehen, dass die Wandversteifung eine Expansion eines sich über den Klemmkörper hinaus erstreckenden Abschnitts des expandierbaren Elements auf den Klemmkörper überträgt.

Die Wandversteifung könnte in unterschiedlichster Art und Weise ausgeführt sein.

Beispielsweise könnte die Wandversteifung in eine Wand des expandierbaren Elements integriert sein. Besonders günstig ist es jedoch, wenn die Wandversteifung als ein vom expandierbaren Element getrenntes Element ausgebildet ist.

Die Wandversteifung könnte dabei halbschalenähnlich das expandierbare Element umschließen.

Eine besonders einfache Realisierungsform sieht vor, dass die Wandversteifung als Versteifungsstreifen ausgebildet ist.

Ein derartiger Versteifungsstreifen könnte beispielsweise ein Materialstreifen aus Kunststoff oder aus einem Metall sein.

Besonders zweckmäßig ist es dabei, wenn der Versteifungsstreifen aus einem teilflexiblen Material ist, so dass dieser sich in Grenzen an die Form des expandierbaren Elements anpassen kann.

Beispielsweise ist in diesem Fall der Versteifungsstreifen als schmaler Stahlstreifen aus Federstahl oder aus einem teilflexiblen Kunststoff ausgebildet.

Eine besonders zweckmäßige Lösung sieht vor, dass der Versteifungsstreifen längs der vom expandierbaren Element beaufschlagbaren Klemmkörper einer der Reihen von Stützelementen verläuft.

Hinsichtlich der Ausbildung des Basisgehäuses wurden bislang keine näheren Angaben gemacht. So sieht ein vorteilhaftes Ausführungsbeispiel vor, dass das Basisgehäuse zur Aufnahme der Klemmkörper und des expandierbaren Elements zwei Gehäuseteile aufweist.

Damit lassen sich die Klemmkörper und das expandierende Element in einfacher Weise innerhalb des Basisgehäuses montieren.

Besonders günstig ist es, wenn eine Trennebene der Gehäuseteile durch die Betätigungseinrichtung verläuft, so dass diese in einfacher Weise montiert werden kann.

Ferner ist es zur Fixierung des expandierbaren Elements günstig, wenn das expandierbare Element durch die Gehäuseteile endseitig klemmbar ist und somit in einfacher Weise beim Zusammenbau der Gehäuseteile innerhalb des Basisgehäuses fixiert werden kann.

Der Vorteil der erfindungsgemäßen Lösung ist außerdem auch darin zu sehen, dass die Klemmkörper eine einfache Möglichkeit der Fixierung der Stützelemente durch Kraftschluss erlauben und dass außerdem durch die Betätigungseinrichtung diese Klemmkörper in einfacher Weise beaufschlagbar sind, um diese zu veranlassen, die Stützelemente durch Klemmung festzulegen.

Die Klemmkörper könnten in unterschiedlichster Art und Weise ausgebildet sein.

Beispielsweise könnten die Klemmkörper mehrteilige, in der Art von Spannfuttern ausgebildete Einrichtungen sein.

Eine konstruktiv besonders einfache Lösung sieht vor, dass die Klemmkörper als Klemmhülsen ausgebildet sind.

Derartige Klemmhülsen könnten beispielsweise aus Metall hergestellt sein und die Stützelemente klemmende Lamellen aufweisen.

Eine besonders einfache und zweckmäßige Lösung sieht jedoch vor, dass die Klemmhülsen aus einem elastischen Material hergestellt sind.

Besonders günstig lassen sich die Stützelemente dann festlegen, wenn die Klemmhülsen aus einem eine hohe Haftreibung an den Stützelementen aufweisenden Material ausgebildet sind.

Zweckmäßigerweise ist vorgesehen, dass die Klemmhülsen aus Gummi ausgebildet sind, da durch derartige aus Gummi ausgebildete Klemmhülsen eine hohe Reibung an den Stützelementen realisierbar ist.

Hinsichtlich der Kosten ist es besonders günstig, wenn die Klemmhülsen als Gummischlauchstücke ausgebildet sind, so dass diese in einfacher Weise von einem Gummischlauch durch Abbrennen von Segmenten herstellbar sind.

Eine andere vorteilhafte Lösung sieht vor, dass die Verschiebeeinheiten mit Druckluftzufuhr arbeiten.

In diesem Fall ist es besonders günstig, die Druckluft so den Verschiebeeinheiten zuzuführen und aus diesen abzuleiten, dass dadurch eine luftpolsterunterstützte Führung der Stützelemente entsteht.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: eine perspektivische Ansicht eines ersten Ausführungs- beispiels eines erfindungsgemäßen Stützelements;
- Fig. 2: einen Schnitt längs Linie 2-2 in Fig. 1 bei nicht expandiertem Schlauchkörper;
- Fig. 3: einen teilweise dargestellten Schnitt längs Linie 3-3 in Fig. 2;
- Fig. 4: eine Darstellung ähnlich Fig. 2 bei expandiertem Schlauch- körper;
- Fig. 5: einen Schnitt längs Linie 3-3 in Fig. 2 in einem dem in Fig. 3 dargestellten Bereich gegenüberliegenden Bereich;
- Fig. 6: einen Schnitt ähnlich Fig. 2 durch ein zweites Ausführungs- beispiel einer erfindungsgemäßen Stützeinheit;
- Fig. 7: einen Schnitt ähnlich Fig. 4 durch das zweite Ausführungs- beispiel der erfindungsgemäßen Stützeinheit;
- Fig. 8: einen Schnitt durch eine Druckerzeugungsvorrichtung bei einem dritten Ausführungsbeispiel;
- Fig. 9: einen Schnitt durch eine Druckerzeugungsvorrichtung eines vierten Ausführungsbeispiels.

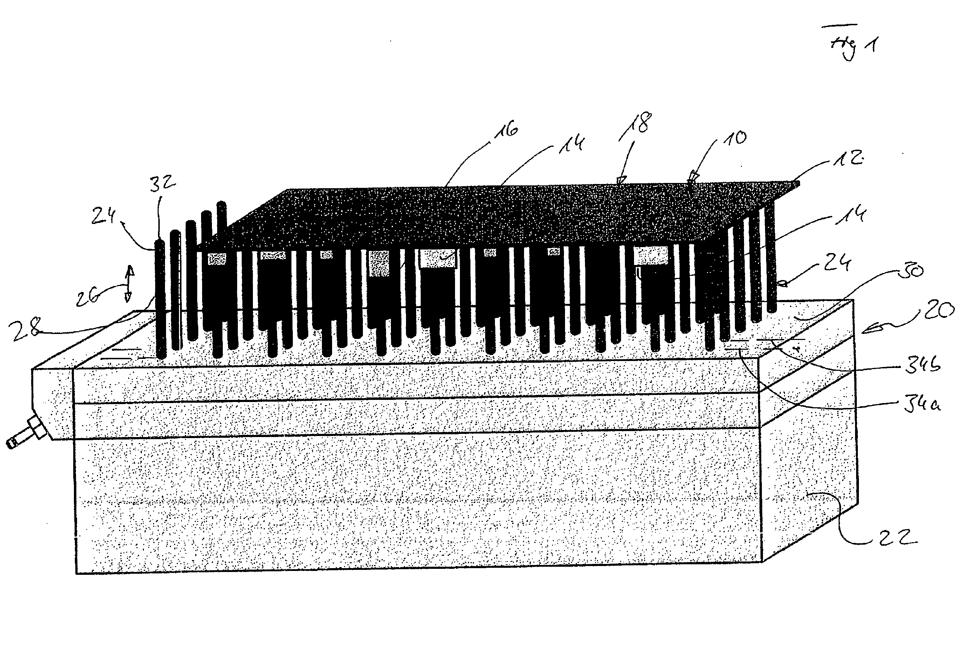

Ein Ausführungsbeispiel einer erfindungsgemäßen Stützeinheit, dargestellt in Fig. 1, dient zur Abstützung einer Baugruppe 10, welche beispielsweise eine Platine 12 umfasst, auf welcher Bauteile 14 angeordnet sind, die insgesamt relativ zur Platine 12 eine höhenvariierende Oberflächenkontur 16 ergeben.

Um die Baugruppe 10 auf dieser höhenvariierenden Oberflächenkontur 16 abstützen zu können, beispielsweise beim Auftragen von Lot oder anderen Materialien auf einer den Bauteilen gegenüberliegende Seite 18 der Platine 12, ist eine als Ganzes mit 20 bezeichnete Stützeinheit vorgesehen, welche ein Basisgehäuse 22 umfasst, in welchem eine Vielzahl von Stützelementen 24 in einer Verschieberichtung 26 beweglich gelagert sind, wobei die Stützelemente 24 sich mit parallel zueinander verlaufenden Schäften 28 und im Abstand voneinander über eine Oberseite 30 des Basisgehäuses 22 hinauserstrecken, und zwar bis zu einem Stützkopf 32, der allerdings in unterschiedlichem Abstand von der Oberseite 30 angeordnet ist, je nach dem, ob der Stützkopf 32 eines der Bauteile 14 oder die Platine 12 direkt abstützt.

Wie in Fig. 1 außerdem dargestellt, sind die Stützelemente 24 im Abstand voneinander in Reihen 34 angeordnet, die ebenfalls im Abstand voneinander parallel zueinander verlaufen, so dass in einem definierten Flächenmuster Stützelemente 24 zur Abstützung der Baugruppe 10 zur Verfügung stehen.

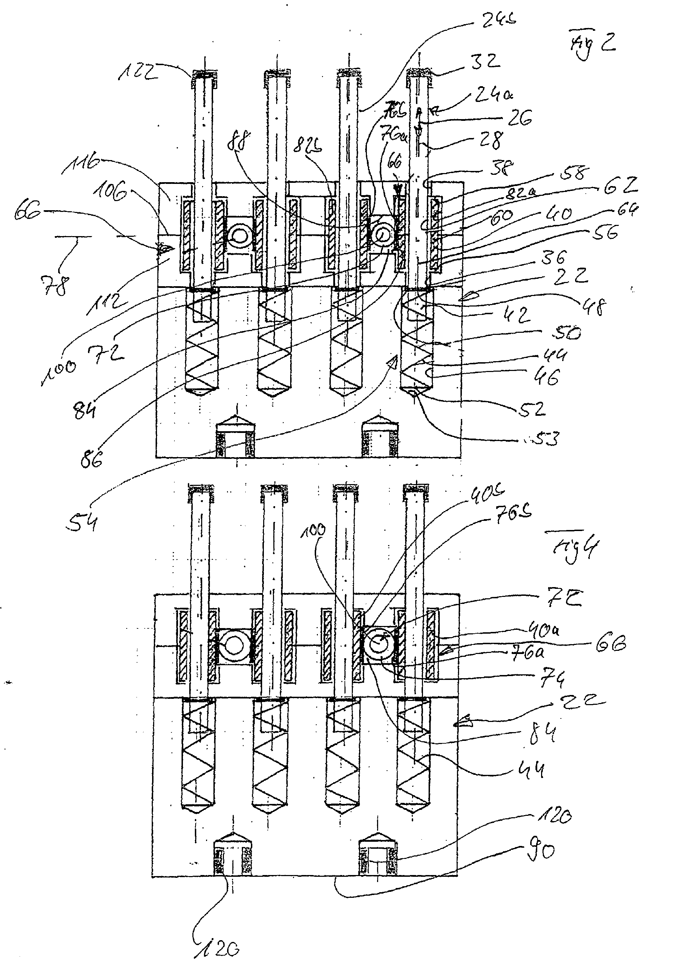

Die Stützelemente 24 sind, wie in Fig. 2 dargestellt, mit ihrem jeweiligen Schaft 28 in dem Basisgehäuse 22 in der Verschieberichtung 26 beweglich geführt, wobei eine Führung des jeweiligen Schafts 28 durch Führungsflächen 36, 38 des Basisgehäuses 22 erfolgt, die vorzugsweise beiderseits eines als Ganzes mit 40 bezeichneten Klemmkörpers angeordnet sind.

Ferner ist jeder Schaft 28 in einem dem Stützkopf 32 abgewandten Endbereich 42 durch einen elastischen Kraftspeicher 44 beaufschlagbar, welcher in einer Ausnehmung 46 im Basisgehäuse 22 angeordnet ist und mit einem Ende 48 auf eine Schulter 50 des jeweiligen Stützelements 24, beispielsweise gebildet durch eine am Schaft 28 im Endbereich 42 gehaltene Scheibe, wirkt, während sich der Kraftspeicher 44 mit seinem anderen Ende 52 an einem Boden 53 der Ausnehmung 46 abstützt. Der in der Ausnehmung 46 angeordnete Kraftspeicher 54 und die Schulter 50 bilden somit insgesamt eine Verschiebeeinrichtung 54 für jedes Stützelement 24.

Vorzugsweise liegen dabei der Kraftspeicher 44 und die Ausnehmung 46 auf einer dem Stützkopf 32 abgewandten Seite des Klemmkörpers 40.

Der Klemmkörper 40 ist in der Verschieberichtung 26 unverschieblich in dem Basisgehäuse 22 gehalten, beispielsweise durch Anordnung desselben zwischen zwei vom Basisgehäuse 22 gebildeten Halteschultern 56, 58.

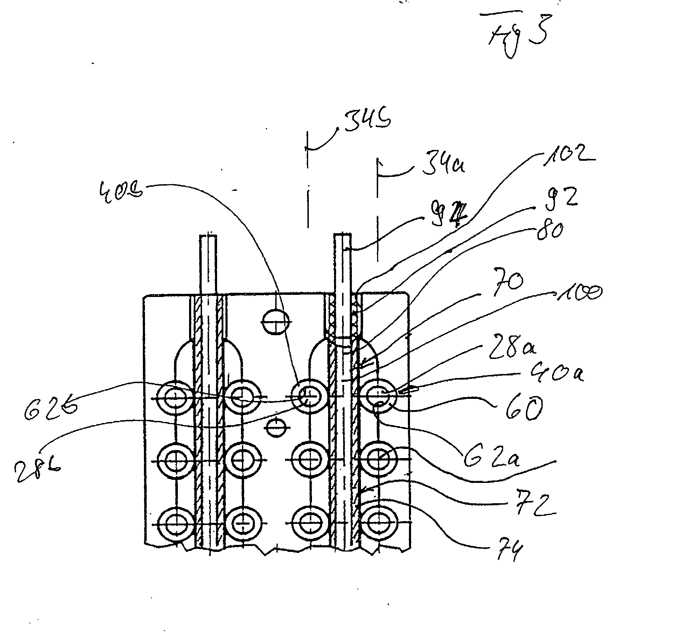

Vorzugsweise ist der Klemmkörper 40, wie in Fig. 3 dargestellt, als den jeweiligen Schaft 28 umfassende Hülse 60 aus einem elastischen Material, vorzugsweise aus einem Schlauchstück aus Gummi ausgebildet, so dass der Schaft 28 einen inneren Durchbruch 62 der Hülse 60 durchsetzt.

Dadurch, dass die Hülse 60 aus einem elastischen Material hergestellt ist, lässt sich der Schaft 28 in dem Durchbruch 62 der Hülse 60 kraftschlüssig dann festlegen, wenn auf die Hülse 60 eine in radialer Richtung zu einer Längsrichtung 64 des Schafts 28 gerichtete Kraft einwirkt, welche die Hülse 60 mit auf einer Seite des Schafts 28 anlegt und damit eine kraftschlüssige Verbindung zwischen dem Schaft 28 und der Hülse 60 schafft.

Zur Betätigung jeder Fixiereinheit 66 wie in Fig. 2, 3 und 4 dargestellt, eine Betätigungseinrichtung 70 vorgesehen, welche einen expandierbaren Schlauchkörper 72 umfasst, dessen Mantel 74 bei einer Expansion desselben auf den Klemmkörper 40 wirkt.

Um die vom expandieren Schlauchkörper 72 erzeugbare Kraft auf die Hülse 60 optimal ausnützen zu können, ist der expandierbare Schlauchkörper 72 noch mit einer Wandversteifung 76 versehen, die zwischen dem Mantel 74 und der Hülse 60 liegt und sich längs des Schlauchkörpers 72 erstreckt.

Wie in den Fig. 2 bis 4 erkennbar, dient die Betätigungseinrichtung 70 zum Betätigen der Klemmkörper 40 zweier nebeneinander verlaufender Reihen 34a und 34b von Stützelementen 24, wobei sich der expandierbare Schlauchkörper 72 zwischen den beiden Reihen 34a und 34b quer zu der Längsrichtung 64 der Schäfte 28 der jeweiligen Stützelemente 24 erstreckt, vorzugsweise in einer senkrecht zu diesen liegenden Ebene 78 liegt.

Ferner liegt der Schlauchkörper zwischen den Klemmkörpern 40a, 40b der Stützelemente 24 der beiden Reihen, so dass eine Expansion des Mantels 77 des Schlauchkörpers 72 auf die auf gegenüberliegenden Seiten des expandierbaren Schlauchkörpers 72 liegenden Wandversteifungen 76a, 76b wirkt und über diese die auf gegenüberliegenden Seiten des expandierbaren Schlauchkörpers 72 angeordneten Klemmkörper 40a, 40b beaufschlagt.

Vorzugsweise liegen dabei die Klemmkörper 40a, 40b bezogen auf eine Längsrichtung 80 des expandierbaren Schlauchkörpers 72 auf gegenüberliegenden Seiten, so dass der Mantel 74 des expandierbaren Schlauchkörpers 72 im expandierten Zustand, wie in Fig. 4 dargestellt, zwischen den einander gegenüberliegenden Wandversteifungen 76a, 76b eingeklemmt ist und dadurch auf diese drückt, die ihrerseits wiederum mit ihren dem expandierbaren Schlauchkörper 72 abgewandten Seiten auf die auf gegenüberliegenden Seiten des Schlauchkörpers 72 angeordneten Klemmkörper 40a, 40b wirken und die Klemmkörper 40a, 40b gleichzeitig beaufschlagen.

Vorzugsweise liegen der expandierbare Schlauchkörper 72 und die Wandversteifungen 76a und 76b schwimmend zwischen den Klemmkörpern 40a, 40b der beiden Reihen 34a, 34b von Stützelementen 24a, 24b, so dass sich der expandierbare Schlauchkörper 72 selbst zwischen den Klemmkörpern 40a, 40b, zentriert und mit im wesentlichen derselben Kraft jeden der Klemmkörper 40a, 40b in einer radial zur Längsrichtung 64 des jeweiligen Schafts 28 verlaufenden Richtung beaufschlagt, und damit den jeweiligen Schaft 28a, 28b in dem Durchbruch 62a, 62b des jeweiligen Klemmkörpers kraftschlüssig festlegt, so dass der Schaft 28 aufgrund der Festlegung des Klemmkörpers 40 zwischen den Halteschultern 56 und 58 im Basisgehäuse 22 ebenfalls nicht mehr in der Verschieberichtung 26 relativ zum Basisgehäuse 22 bewegbar ist.

Zur Aufnahme des expandierbaren Schlauchkörpers 72 ist vorzugsweise zwischen im Basisgehäuse 22 vorgesehenen und die Halteschultern 56 und 58 aufweisenden Aufnahmen 82a, 82b für die einander gegenüberliegenden Klemmkörper 40a, 40b ein symmetrisch zur Ebene 78 verlaufender Durchbruch 84 vorgesehen, welcher jeweils im Bereich der Aufnahme 82a, 82b diese durchdringt und sich zwischen den beiden Reihen 34a, 34b von Stützelementen 24 über die gesamte Längsausdehnung der Reihen 34a, 34b von Stützelementen 24a, 24b erstreckt.

Ferner ist der Durchbruch 84 ebenfalls noch so ausgebildet, dass die Wandversteifungen 76a, 76b durch eine sich ungefähr zur Ebene 78 parallel erstreckende Bodenfläche 86 sowie eine sich ungefähr parallel zur Ebene 78 erstreckende Deckelfläche 88 des Durchbruchs 84 geführt sind.

Vorzugsweise ist der Durchbruch 84 symmetrisch zur Ebene 78 ausgebildet, so dass auch die Bodenfläche 86 und die Deckelfläche 88 symmetrisch zur Ebene 78 liegen.

Ferner verläuft auch der expandierbare Schlauchkörper 72 vorzugsweise ungefähr symmetrisch zur Ebene 78 in gleicher Weise wie die Wandversteifungen 76a und 76b.

Insbesondere ist der Abstand der Bodenfläche 86 von der Wandfläche 88 beim jeweiligen Durchbruch so gewählt, dass, wie in Fig. 4 dargestellt, bei expandiertem Schlauchkörper 72 der Mantel 74 im Wesentlichen an diesen anliegt, so dass der expandierbare Schlauchkörper 72 im expandierten Zustand auch an der Bodenfläche 86 und der Deckelfläche 88 abgestützt ist, die einander gegenüberliegen, und außerdem ist der expandierte Schlauchkörper 72 an den quer zu diesen verlaufenden Wandversteifungen 76a und 76b in einer ungefähr parallel zur Bodenfläche 86 oder Deckelfläche 88 verlaufenden Richtung auf gegenüberliegenden Seiten ebenfalls abgestützt.

Im expandierten Zustand des Schlauchkörpers 72 werden daher die Wandversteifungen 76a und 76b durch den Mantel 74 des expandierbaren Schlauchkörpers 72 beaufschlagt und auseinanderbewegt, um auf die Klemmkörper 40a, 40b zum Festlegen der Schäfte 28 der Stützelemente 24 einzuwirken.

Die erfindungsgemäße Stützeinheit 20 funktioniert nun so, dass die von den Kraftspeichern 44 ausgeübten Kräfte ausreichend stark sind, um im unbelasteten Zustand der Stützelemente 24 diese maximal aus dem Basisgehäuse 22 auszufahren und somit die Stützköpfe 32 im maximalen möglichen Abstand von der Oberseite 30 des Basisgehäuses 22 zu positionieren.

Bei Auflegen der Baugruppe auf die durch die Stützkörper 32 der Stützelemente 24 zur Verfügung gestellten Abstützstellen werden die Stützelemente 24 in der Verschieberichtung 26 zumindest dann, wenn diese auf einem Bauteil 14 aufsitzen, in Richtung des Basisgehäuses 22 gegen die Kraft der einzelnen Kraftspeicher 44 verschoben, und zwar so, dass in der Regel jedes der Stützelemente 24 die zu unterstützende Baugruppe 10, beispielsweise entweder an der Platine 10 oder an einem Bauteil 14, abstützt, wodurch die Stützelemente 24 bei Abstützen der Baugruppe 10 in einer unterschiedlich weit aus dem Basisgehäuse 22 ausgefahrenen Stellung stehen.

Die Kraftspeicher 44 sind vorzugsweise so ausgebildet, dass die Summe aller die Baugruppe 10 auf der Oberflächenkontur 16 mit ihren Stützköpfen 32 beaufschlagenden Stützelemente 24 in der Lage ist die, Baugruppe im unbeaufschlagten Zustand zu tragen.

Dabei sind üblicherweise diejenigen Stützelemente 24, die die Oberflächenkontur 16 in ihrer tiefsten Stelle, also beispielsweise die Platine 12 direkt, beaufschlagen, maximal aus dem Basisgehäuse 22 ausgefahren, das heißt, sie steht in ihrer in Fig. 2 oder 4 dargestellten maximal ausgefahrenen Stellung, während diejenigen Stützelemente 24, die mit ihren Stützköpfen 32 eines der Bauteile 14 auf der Platine 12 beaufschlagend abstützen in einer teilweise in das Basisgehäuse 22 eingefahrenen Stellung stehen.

Die Stützelemente 24 lassen sich erfindungsgemäß in allen beliebigen Stellungen, das heißt sowohl in der maximal ausgefahrenen Stellung als auch einer maximal eingefahrenen Stellung oder einer Zwischenstellung durch expandieren des Schlauchkörpers 72 kraftschlüssig in den Durchbrüchen 62 der Klemmelemente 40 und somit auch kraftschlüssig relativ zum Basisgehäuse 22 festlegen, so dass die Baugruppe 10 auf ihrer Seite 18 mit zusätzlichen Kräften beaufschlagt werden kann, die über die Summe aller Stützelemente 24 und deren kraftschlüssige Festlegung relativ zum Basisgehäuse 22 vom Basisgehäuse 22 aufgenommen und vom Basisgehäuse 22 über eine Fußfläche 90 weitergegeben werden kann.

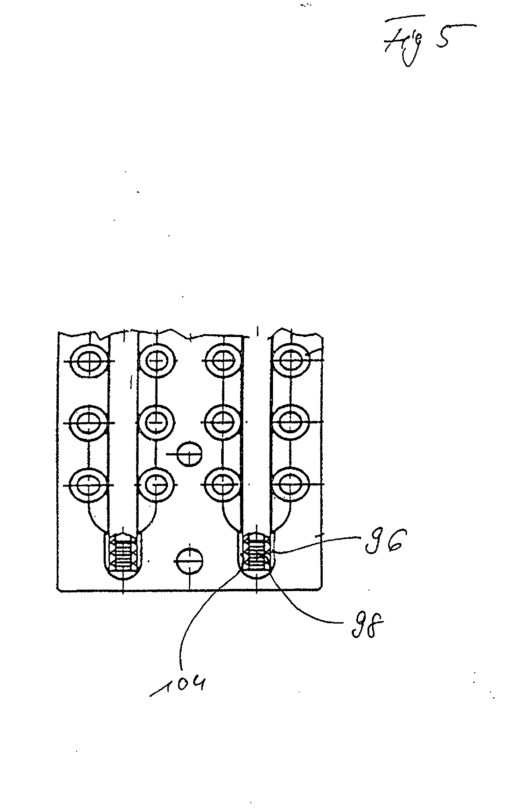

Wie in Fig. 3 und 5 dargestellt, ist der expandierbare Schlauchkörper 72 im Bereich eines Endes 92 mit einem Druckanschluss 94 versehen und im Bereich eines gegenüberliegenden Endes 96 beispielsweise über einen Blindstopfen 98 verschlossen. Durch Zuführen von einem unter Druck stehenden Medium über den Druckanschluss 94 ist der Schlauchkörper 72 in einfacher Weise durch das zuführbare Medium expandierbar, wobei dieses Medium ein flüssiges oder gasförmiges Medium sein kann.

Im einfachsten Fall lässt sich hierzu Luft einsetzen.

Besonders günstig ist der expandierbare Schlauchkörper 72 dann in dem Basisgehäuse 22 fixierbar und festlegbar, wenn die Enden 92 und 96 desselben in Bohrungen 102 und 104 des Basisgehäuses 22 liegen und durch den eingesetzten Druckanschluss 94 bzw. den eingesetzten Blindstopfen 98 aufgrund der durch diese bedingten Aufweitung der Enden 92 bzw. 96 kraftschlüssig fixiert sind, so dass insgesamt eine Festlegung des expandierbaren Schlauchkörpers 72 in dem Durchbruch 84 gegeben ist.

Um einen einfachen Zusammenbau des Basisgehäuses 22, insbesondere im Bereich der Aufnahmen 82 für die Klemmkörper 40 und die Durchbrüche 84 für die expandierbaren Schlauchkörper 72 sowie die Wandversteifungen 76 zu erreichen, ist vorzugsweise das Basisgehäuse 22 mit einer mit der Ebene 78 zusammenfallenden Trennebene 106 versehen, so dass der die Aufnahmen 82 und die Durchbrüche 84 umfassende Bereich des Basisgehäuses 22 in zwei Teile 112 und 116 zerlegbar ist, um die Klemmelemente 40 sowie die Betätigungseinrichtung 70 mit dem Schlauchkörper 72 und den Wandversteifungen 76 einfach montieren zu können, da die Trennebene 106 vorzugsweise sowohl die Aufnahmen 82 als auch die Durchbrüche 84 ungefähr hälftig durchtrennt.

Zur Montage der erfindungsgemäßen Stützeinheit 20 in einer Vorrichtung sind beispielsweise im Bereich nahe der Fußfläche 90 Halteelemente 120 vorgesehen, die entweder als Gewindelöcher ausgebildet sein können oder als Haltemagnete, um die Stützeinheiten magnetisch auf einem Untergrund zu fixieren.

Darüber hinaus ist vorzugsweise der Stützkopf 32 jedes Stützelements 24 mit einer Kappe 122 aus elektrisch leitfähigem Kunststoff versehen, um die Baugruppe 10, insbesondere Bauteile 14 derselben beim Abstützen nicht zu beschädigen.

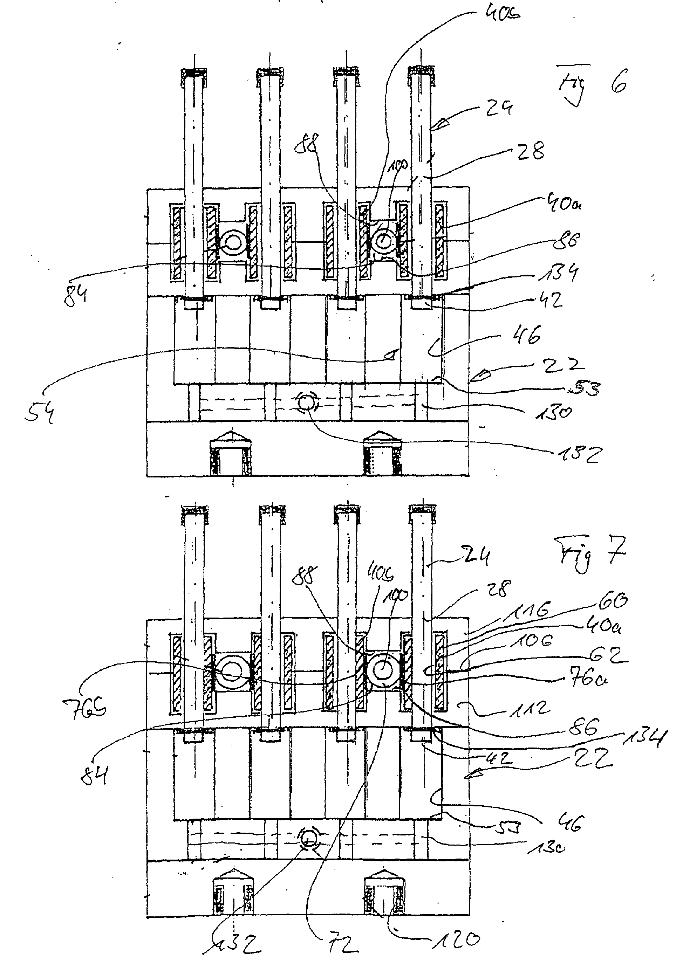

Bei einem zweiten Ausführungsbeispiel einer erfindungsgemäßen Stützeinheit 20, dargestellt in Fig. 6 und Fig. 7 sind diejenigen Elemente, die mit denen des ersten Ausführungsbeispiels identisch sind, mit denselben Bezugszeichen versehen, so dass hinsichtlich der Beschreibung derselben vollinhaltlich auf die Ausführungen zum ersten Ausführungsbeispiel Bezug genommen werden kann.

Im Gegensatz zum ersten Ausführungsbeispiel sind in den Ausnehmungen 46 keine Kraftspeicher 44 angeordnet, sondern die Ausnehmungen 46 sind über Druckkanäle 130 mit einem Druckanschluss 132 verbunden, über welchen ein unter Druck stehendes Medium den Ausnehmungen 46 im Bereich ihres Bodens 53 zugeführt werden kann.

Sind die Schäfte 28 in deren Endbereichen 42 mit einem Flanschkörper 134 versehen, welcher zwar nicht zwingend dichtend an Wandflächen der Ausnehmungen 46 anliegt, jedoch im wesentlichen bis zu Wandflächen derselben reicht. Somit lässt sich durch einen ständigen Strom eines über die Druckkanäle 130 den Ausnehmungen 46 im Bereich ihres Bodens 54 zugeführten Mediums erreichen, dass dieses Medium auf die Flanschkörper 134 und die Schäfte 28 wirkt und die Schäfte 28 der Stützelemente 24 in Richtung ihrer maximal ausgefahrenen Stellung verschiebt.

Damit lassen sich die Stützelemente 24 in gleicher Weise wie beim ersten Ausführungsbeispiel alle so positionieren, dass jedes der an der Baugruppe 10 anlegbaren Stützelemente 24 mit seinem Stützkopf 32 an der Baugruppe 10 anliegt und diese im ansonsten unbelasteten Zustand unterstützt, so dass sich insgesamt die Baugruppe durch die Gesamtheit aller im Bereich der Baugruppe 10 angeordneten Stützelemente 24 abstützen lässt.

Dabei lässt sich die Kraft, mit welcher die Stützelemente 24 auf die Baugruppe 10 wirken, durch Variation des Drucks des über den Druckanschluss 132 und die Druckkanäle 130 den Ausnehmungen 46 zugeführten Mediums einstellen, so dass je nach Gewicht der Baugruppe 10 eine Anpassung der von den Stützelementen 24 ausgeübten Kräfte möglich ist.

Ist dann die unbelastete Baugruppe 10 durch sämtliche zu deren Abstützung heranziehbaren Stützelemente 24 abgestützt, so kann dann die Fixierung der Stützelemente 24 durch die Klemmkörper 40 erfolgen.

Das an den Flanschkörpern 134 vorbeiströmende Medium umströmt dabei jeweils den Schaft 28 und durchströmt die Führungsflächen 36, die Klemmkörper 40 und die Führungsflächen 38, so dass das Medium im Bereich der Oberseite 30 des Basisgehäuses 22 wieder aus diesem austritt.

Durch eine derartige Führung des Mediums werden nicht nur die Stützelemente 24 mit einer Kraft in Richtung der maximal ausgefahrenen Stellung beaufschlagt, sondern gleichzeitig wird die Reibung des jeweiligen Schafts 28 im Bereich der Führungsflächen 36 und 38 sowie der Klemmkörper 40 reduziert, so dass der Schaft 28 in der Verschieberichtung 26 leicht bewegbar ist und somit bereits durch geringe von dem zugeführten Medium ausgeübte Kräfte in seine maximal ausgefahrene Stellung bewegt werden kann.

Somit lassen sich insbesondere auch geringe, auf die Stützelemente 24 wirkende Kräfte einstellen, um mit wenig Kraft empfindliche Bauteile 14 der Baugruppe 10 beaufschlagen zu können.

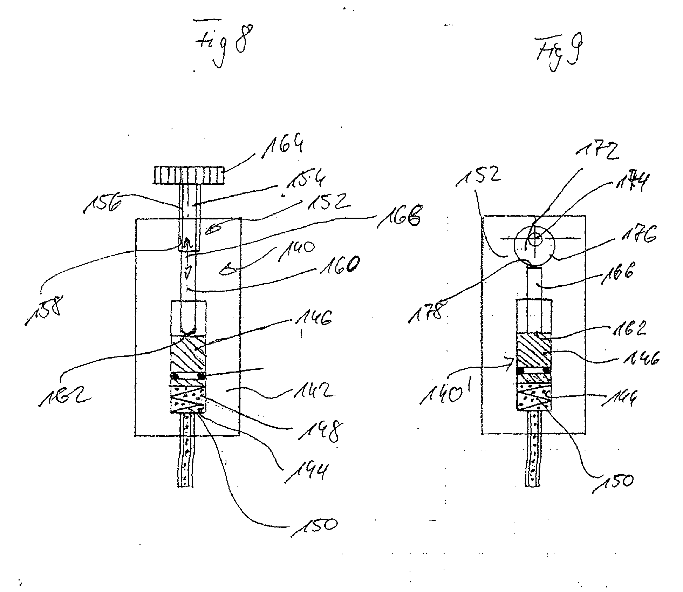

Im Rahmen des ersten und zweiten Ausführungsbeispiels wurde die Erzeugung des Drucks in dem expandierbaren Schlauchkörper 72 nicht näher erläutert. Beispielsweise lässt sich eine Druckerzeugung 140 einsetzen, wie sie in Fig. 8 dargestellt ist.

Diese Druckerzeugung 140 umfasst einen Zylinderkörper 142, in welchem eine Zylinderkammer 144 angeordnet ist, innerhalb von welcher ein Kolben 146 bewegbar ist.

Mit dem Kolben lässt sich das Volumen der Zylinderkammer 144 variabel vergrößern und somit Medium 148 aufnehmen oder in den Innenraum 100 des expandierbaren Schlauchkörpers 72 einführen, um dessen Mantel 74 zu expandieren.

Vorzugsweise ist dabei der Kolben 146 durch einen federelastischen Kraftspeicher 150 in Richtung einer einem maximalen Zylinderkammervolumen entsprechenden Stellung beaufschlagt, so dass der Kolben 146 selbsttätig die Tendenz hat, stets in die Stellung überzugehen, in welcher die Zylinderkammer 144 das größte Volumen hat.

Der Kolben ist ferner durch eine Beaufschlagungsvorrichtung 152 beaufschlagbar, welche eine Gewindespindel 154 umfasst, welche mit ihrem Gewindeabschnitt 156 in ein Innengewinde 158 des Zylinderkörpers eingreift und mit einem Fortsatz 160 den Kolben 146 beaufschlagt, wobei der Fortsatz 160 mit einem vorderen Ende 162 an dem Kolben 146 anliegt, wobei der Kolben 146 seinerseits aufgrund des federelastischen Elements 150 an dem Ende 162 in Anlage gehalten wird.

Je nach Drehung der Gewindespindel 154, beispielsweise über ein Handbetätigungselement 164, lässt sich die Gewindespindel 156 und somit der Fortsatz 160 in einer Verschieberichtung 168 bewegen und somit kann der Kolben 146 entgegengesetzt zur Wirkung des federelastischen Elements 150 in Richtung einer Verkleinerung des Zylinderkammervolumens verschoben werden, so dass dadurch das Medium 148 in den Innenraum 100 des expandierbaren Schlauchkörpers 72 überführt wird, der dadurch expandiert und die Klemmkörper 40 beaufschlagt.

Andererseits lässt sich durch Verdrehen der Gewindespindel 156 das Ende 162 in Richtung der Kraftwirkung des federelastischen Elementes 150 bewegen, so dass der Kolben aufgrund der Wirkung des federelastischen Elements 150 sich in Richtung einer das Zylinderkammervolumen vergrößernden Stellung bewegt und Medium 148 aus dem Innenraum 100 des expandierbaren Schlauchkörpers 72 in die Zylinderkammer 44 überführt wird, so dass der expandierbare Schlauchkörper 72 sein Volumen verkleinert und nicht mehr die Klemmkörper 40 einwirkt.

Bei einem vierten Ausführungsbeispiel, dargestellt in Fig. 9, sind diejenigen Teile, die mit denen des dritten Ausführungsbeispiels identisch sind, mit denselben Bezugszeichen versehen.

Im Gegensatz zum dritten Ausführungsbeispiel umfasst die Beaufschlagungsvorrichtung 152 einen Exzenterkörper 172, welcher um eine Drehachse 174 drehbar in dem Zylinderkörper 142 gelagert ist.

Der Exzenterkörper 172 wirkt seinerseits mit seiner Umfangsfläche 176 auf ein Ende 178 des Stößels 166, der seinerseits wiederum mit dem Ende 162 in bekannter Weise auf den Kolben 146 wirkt.

Durch Verdrehen des Exzenterkörpers 172 kann nun der Stößel 166 so verschoben werden, dass er den Kolben 146 in eine, das Zylinderkammervolumen verkleinernde Stellung bewegt oder in eine das Zylinderkammervolumen vergrößernde Stellung zulässt, in welche der Kolben 146 aufgrund der Wirkung des federelastischen Elements 150 bewegbar ist.

Insoweit, als beim vierten Ausführungsbeispiel die gleichen Teile Verwendung finden, wie beim dritten Ausführungsbeispiel, sind dieselben Bezugszeichen verwendet und es wird hinsichtlich der Beschreibung dieser Teile vollinhaltlich auf die Ausführungen zum vierten Ausführungsbeispiel Bezug genommen.

Als Medium kann bei einer Druckerzeugungsvorrichtung gemäß dem dritten oder vierten Ausführungsbeispiel sowohl ein gasförmiges Medium als auch ein flüssiges Medium, das heißt beispielsweise Luft als gasförmiges Medium oder Öl als flüssiges Medium Verwendung finden.

## Patentansprüche

1. Stützeinheit für die Abstützung einer Baugruppe (10) auf einer höhenvariierenden Oberflächenkontur (16), insbesondere für die Abstützung von mit Bauteilen bestückten Leiterplatten, umfassend ein Basisgehäuse (22), in welchem mehrere Stützelemente (24) in Richtung ihrer Längsrichtung zwischen einer eingefahrenen Stellung und einer ausgefahrenen Stellung bewegbar geführt sind, Verschiebeeinheiten (54), mit denen die Stützelemente (24) in Richtung der ausgefahrenen Stellung beaufschlagbar sind, wobei die Verschiebeeinheiten (54) mit Druckluftzufuhr arbeiten und die Druckluft so den Verschiebeeinheiten (54) zuführbar ist, dass diese druckluftbetätigt die Stützelemente (24) in Richtung ihrer ausgefahrenen Stellung beaufschlagen, und Fixiereinheiten (66), mit welchen die Stützelemente (24) in ihren jeweiligen Stellungen gegenüber dem Basisgehäuse (22) fixierbar sind, wobei die Fixiereinheiten (66) auf die Stützelemente (24) wirkende Klemmkörper umfassen, die durch eine Betätigungseinrichtung (70) beaufschlagbar sind,
**dadurch gekennzeichnet, dass** die Stützelemente (24) Schäfte (28) aufweisen, die in ihren Endbereichen (42) mit Flanschkörpern (134) versehen sind, dass die Flanschkörper (134) in Ausnehmungen (46) angeordnet sind, welchen ein ständiger Strom von Druckluft zuführbar ist, der an den nicht dichtend zu Wandflächen der Ausnehmungen (46) angeordneten Flanschkörpern (134) vorbeiströmt, dass durch aus den Verschiebeeinheiten (54) abgeleitete Druckluft die Stützelemente (24) im Basisgehäuse (22) luftpolsterunterstützt geführt sind, dass die an den Flanschkörpern (134) vorbeiströmende Druckluft Führungsflächen (36, 38) des Basisgehäuses (22) für die Schäfte (28) und die Klemmkörper (40) durchströmt und im Bereich einer Oberseite des Basisgehäuses (22) aus diesem austritt.

2. Stützeinheit nach einem der voranstehenden Ansprüche, **dadurch gekennzeichnet, dass** die Betätigungseinrichtung (70) mittels eines unter Druck setzbaren Mediums eine Kraftwirkung auf die Klemmkörper (40) ausübt.

3. Stützeinheit nach Anspruch 2, **dadurch gekennzeichnet, dass** die Betätigungseinrichtung (70) mindestens ein durch das Medium expandierbares Element (72) aufweist, welches auf mindestens einen der Klemmkörper (40) einwirkt.

4. Stützeinheit nach Anspruch 3, **dadurch gekennzeichnet, dass** die Betätigungseinrichtung als expandierbares Element einen expandierbaren Schlauchkörper (72) aufweist.

5. Stützeinheit nach Anspruch 4, **dadurch gekennzeichnet, dass** der Schlauchkörper (72) quer zu den Längsrichtungen (64) der Stützelemente (24) verläuft.

6. Stützeinheit nach Anspruch 4 oder 5, **dadurch gekennzeichnet, dass** mit dem Schlauchkörper (72) mehrere Klemmkörper (40) beaufschlagbar sind.

7. Stützeinheit nach einem der Ansprüche 4 bis 6, **dadurch gekennzeichnet, dass** das expandierbare Element (72) auf seiner auf den Klemmkörper (40) wirkenden Seite mit einer Wandversteifung (76) versehen ist.

8. Stützeinheit nach einem der voranstehenden Ansprüche, **dadurch gekennzeichnet, dass** das Basisgehäuse (22) zur Aufnahme der Klemmkörper (40) und der Betätigungseinrichtung (70) zwei Gehäuseteile (112, 116) aufweist.

9. Stützeinheit nach Anspruch 8, **dadurch gekennzeichnet, dass** eine Trennebene (106) der Gehäuseteile (112, 116) durch die Betätigungseinrichtung (70) verläuft.

10. Stützeinheit nach Anspruch 8 oder 9, **dadurch gekennzeichnet, dass** das expandierbare Element (72) durch die Gehäuseteile (112, 116) endseitig klemmbar ist.

## Claims

1. Support unit for the support of a subassembly (10) on a surface contour (16) variable in height, in particular for the support of printed circuit boards equipped with components, comprising a base housing (22), several supporting elements (24) being guided in said base housing for movement in the direction of their longitudinal direction between a retracted position and an extended position, displacing units (54) for acting on the supporting elements (24) in the direction of the extended position, wherein the displacing units (54) operate with a supply of compressed air and the compressed air is suppliable to the displacing units (54) such that they act on the supporting elements (24) in the direction of their extended position actuated by compressed air, and fixing units (66) for fixing the supporting elements (24) in their respective positions in relation to the base housing (22), wherein the fixing units (66) comprise clamping members acting on the supporting elements (24) and being acted upon by an actuating device (70),
**characterized in that** the supporting elements (24) have shafts (28) provided with flange members (134) in their end areas (42), that the flange members (134) are arranged in recesses (46) which can be supplied with a constant stream of compressed air flowing past the flange members (134) arranged non sealingly with respect to wall surfaces of the recesses (46), that compressed air discharged from the displacing units (54) guides the supporting elements (24) in the base housing (22) supported on cushions of air, that the compressed air flowing past the flange members (134) flows through guiding surfaces (36, 38) of the base housing (22) for the shafts (28) and the clamping members (40) and exits from the base housing (22) in the region of an upper side thereof.

2. Support unit as defined in one of the preceding claims, **characterized in that** the actuating device (70) exerts an effective force on the clamping members (40) by means of a medium subjectable to pressure.

3. Support unit as defined in claim 2, **characterized in that** the actuating device (70) has at least one element (72) expandable by means of the medium, said element acting on at least one of the clamping members (40).

4. Support unit as defined in claim 3, **characterized in that** the actuating device has an expandable hose member (72) as expandable element.

5. Support unit as defined in claim 4, **characterized in that** the hose member (72) extends transversely to the longitudinal directions (64) of the supporting elements (24).

6. Support unit as defined in claim 4 or 5, **characterized in that** several clamping members (40) are adapted to be acted upon with the hose member (72).

7. Support unit as defined in any one of claims 4 to 6, **characterized in that** the expandable element (72) is provided with a wall reinforcement (76) on its side acting on the clamping member (40).

8. Support unit as defined in any one of the preceding claims, **characterized in that** the base housing (22) has two housing sections (112, 116) for accommodating the clamping members (40) and the actuating device (70).

9. Support unit as defined in claim 8, **characterized in that** a plane of separation (106) of the housing sections (112, 116) extends through the actuating device (70).

10. Support unit as defined in claim 8 or 9, **characterized in that** the expandable element (72) is adapted to be clamped at its ends by the housing sections (112, 116).

## Revendications

1. Unité de maintien pour l'appui d'un module (10) sur un contour de surface (16) de hauteur variable, en particulier pour l'appui de plaquettes de circuits imprimés munies de composants, comportant un boîtier de base (22), dans lequel plusieurs éléments de maintien (24) sont logés de manière mobile dans le sens de leur direction longitudinale entre une position introduite et une position extraite, des unités de déplacement (54) par lesquelles les éléments de maintien peuvent être sollicités vers leur position extraite, les unités de déplacement (54) fonctionnant avec une alimentation pneumatique et l'air comprimé pouvant être amené vers les unités de déplacement (54) de telle manière qu'actionnées par l'air comprimé, celles-ci sollicitent les éléments de support (24) vers leur position extraite, et des unités d'immobilisation (66) par lesquelles les éléments de maintien (24) peuvent être immobilisés dans leurs positions respectives par rapport au boîtier de base (22), les unités d'immobilisation (66) comprenant des corps de serrage agissant sur les éléments de maintien (24), lesquels corps de serrage peuvent être sollicités par un dispositif d'actionnement (70),
**caractérisée en ce que** les éléments de maintien (24) comprennent des tiges (28) pourvues de corps de bride (134) à leurs zones d'extrémité (42), **en ce que** les corps de bride (134) sont disposés dans des évidements (46) vers lesquels un courant permanent d'air comprimé peut être conduit, lequel s'écoule à côté des corps de bride (134) disposés de manière non étanche contre des surfaces de paroi des évidements (46), **en ce qu'**un guidage assisté par coussin d'air des éléments de maintien (24) est réalisé dans le boîtier de base (22) par l'air comprimé sortant des unités de déplacement (54), **en ce que** l'air comprimé s'écoulant à côté des corps de bride (134) traverse des surfaces de guidage (36, 38) du boîtier de base (22) pour les tiges (28) ainsi que les corps de serrage (40), et sort du boîtier de base (22) dans la zone d'une face supérieure de celui-ci.

2. Unité de maintien selon la revendication précédente, **caractérisée en ce que** le dispositif d'actionnement (70) applique une force sur les corps de serrage (40) au moyen d'un fluide pouvant être mis sous pression.

3. Unité de maintien selon la revendication 2, **caractérisée en ce que** le dispositif d'actionnement (70) comporte au moins un élément expansible (72) au moyen du fluide, lequel agit sur au moins un des corps de serrage (40).

4. Unité de maintien selon la revendication 3, **caractérisée en ce que** le dispositif d'actionnement comporte un corps tubulaire flexible (72) expansible en tant qu'élément expansible.

5. Unité de maintien selon la revendication 4, **caractérisée en ce que** le corps tubulaire flexible (72) s'étend transversalement aux directions longitudinales (64) des éléments de support (24).

6. Unité de maintien selon la revendication 4 ou 5, **caractérisée en ce que** plusieurs corps de serrage (40) peuvent être sollicités par le corps tubulaire flexible (72).

7. Unité de maintien selon l'une des revendications 4 à 6, **caractérisée en ce que** l'élément expansible (72) est muni d'un raidissement de paroi (76) sur son côté agissant sur le corps de serrage (40).

8. Unité de maintien selon l'une des revendications précédentes, **caractérisée en ce que** le boîtier de base (22) comporte deux parties (112, 116) de boîtier pour loger les corps de serrage (40) et le dispositif d'actionnement (70).

9. Unité de maintien selon la revendication 8, **caractérisée en ce qu'**un plan de séparation (106) des parties (112, 116) de boîtier traverse le dispositif d'actionnement (70).

10. Unité de maintien selon la revendication 8 ou 9, **caractérisée en ce que** l'élément expansible (72) peut être serré côté extrémité par les parties (112, 116) de boîtier.
